# EUROPEAN PATENT SPECIFICATION

(11) **EP 2 424 107 B1**
(45) Date of publication and mention of the grant of the patent: **11.09.2013**
(21) Application number: 11173807.6
(22) Date of filing: 13.07.2011
(51) Int. Cl.: H03F 3/30, H03F 1/30, H03F 1/32, H03F 3/343

(54) **Current-voltage conversion circuit**
Strom-Spannung-Wandlungsschaltung
Circuit de conversion de courant/tension

(30) Priority: 27.08.2010 JP 2010191452; 31.05.2011 JP 2011121135
(43) Date of publication of application: 29.02.2012
(73) Proprietor: Onkyo Corporation, Neyagawa-shi, Osaka 572-8540 (JP)
(72) Inventor: Kawaguchi, Tsuyoshi, Osaka, Osaka 572-8540 (JP); Kitagawa, Norimasa, Osaka, Osaka 572-8540 (JP); Sekiya, Mamoru, Osaka, Osaka 572-8540 (JP); Takehara, Yu, Osaka, Osaka 572-8540 (JP)
(74) Representative: Horn Kleimann Waitzhofer

(56) References cited:
- JP-A- 59 188 207
- JP-A- 2010 035 117
- US-A- 3 536 958
- US-A- 3 866 134
- SALVATORE PENNISI: "A Low-Voltage Design Approach for Class AB Current-Mode Circuits", IEEE TRANSACTIONS ON CIRCUITS AND SYSTEMS II: ANALOG AND DIGITALSIGNAL PROCESSING, INSTITUTE OF ELECTRICAL AND ELECTRONICS ENGINEERS INC, 345 EAST 47 STREET, NEW YORK, N.Y. 10017, USA, vol. 49, no. 4, 1 April 2002 (2002-04-01), XP011071580, ISSN: 1057-7130

## Description

### BACKGROUND OF THE INVENTION

### 1. Field of the Invention

The present invention relates to a current-voltage conversion circuit.

### 2. Description of the Related Art

In general current feedback amplifiers, a PNP transistor and an NPN transistor are provided in an input stage, and an input signal is supplied to a base of the PNP transistor and a base of the NPN transistor. A collector of the PNP transistor is connected to a negative power source, and a collector of the NPN transistor is connected to a positive power source. An emitter of the PNP transistor is connected to the positive power source via a first bias circuit (first constant current circuit), and an emitter of the NPN transistor is connected to the negative power source via a second bias circuit (second constant current circuit). Thus, in general current feedback amplifiers, since a plurality of bias circuits composed of constant current circuits should be provided, a number of parts increases, and a circuit configuration becomes complicated.

US 3 866 134 A discloses a power amplifier having means for self biasing an emitter follower output stage over a range of temperatures comprising two matched transistors having the bases thereof directly coupled together such that the base-emitter potentials of the transistors are equal in magnitude and opposite in direction. Consequently, the output current is dependent only upon the value of the input current and resistance and the output resistance.

Salvatore Pennisi, "A low-voltage design approach for class AB current-mode circuits", IEEE Transactions on Circuits and Systems II: Analog and Digital Signal Processing, published on April 2002, in Volume: 49, Issue: 4, on Pages 273 - 279 describes an approach for designing analog current-mode circuits with very low supply voltages.

JP 2010 035 117 A discloses a current feedback amplifier that amplifies an audio signal is configured so as to compose an amplifier circuit that amplifies an audio signal, and a feedback circuit for an audio signal and a feedback circuit for a direct current component independently of each other in order to improve the quality of the audio signal output from the amplifier circuit, and to have a signal path simplified by eliminating a complicated signal path.

### SUMMARY OF THE INVENTION

It is an object of the present invention to provide a current-voltage conversion circuit that can be simplified.

A current-voltage conversion circuit according to the present invention, comprises: a first transistor provided in an input stage; a second transistor provided in the input stage and having a polarity different from that of the first transistor; and a bias circuit including two capacitors, an NPN transistor and a PNP transistor, wherein one of the two capacitors is directly coupled between an emitter and a collector of the NPN transistor and the other one of the two capacitors is directly coupled between an emitter and a collector of the PNP transistor. A first terminal of the first transistor and a first terminal of the second transistor are connected to an input terminal into which an input current is input, a second terminal of the first transistor is connected to a first predetermined potential, a second terminal of the second transistor is connected to a second predetermined potential, the bias circuit is connected between the control terminal of the first transistor and the control terminal of the second transistor, so that the collector of the NPN transistor is connected to the control terminal of the first transistor, and the collector of the PNP transistor is connected to the control terminal of the second transistor the emitter of the NPN transistor and the emitter of the PNP transistor are connected to each other and are grounded.

In this case, the bias circuit is connected between the control terminal of the first transistor and the control terminal of the second transistor. For this reason, the bias circuit is in a pulled-up state (also called as a floating state), and a plurality of bias circuits does not have to be provided, thereby simplifying the circuit configuration.

Since the bias circuit can be provided between the first transistor and the second transistor, the bias circuit can compensate the changed temperatures of the first transistor and the second transistor. As a result, the temperature stability in the current-voltage conversion circuit according to the present invention can be improved.

Preferably, the current-voltage conversion circuit further comprises: a first resistor, a second resistor, a third resistor and a fourth resistor. The first resistor is connected between the first terminal of the first transistor and the input terminal, the second resistor is connected between the first terminal of the second transistor and the input terminal, the third resistor is connected to the second terminal of the first transistor, the fourth resistor is connected to the second terminal of the second transistor.

In this case, the amplification can be satisfactorily carried out at the input stage. That is to say, the amplifying amount can be determined by the ratio of the first resistor and the third resistor, and the ratio of the second resistor and the fourth resistor. As a result, the linearity of the amplification can be improved.

Preferably, the current-voltage conversion circuit further comprises: a third transistor whose control terminal is connected to the second terminal of the first transistor and whose second terminal is connected to an output terminal of the current-voltage conversion circuit, a fourth transistor whose control terminal is connected to the second terminal of the second transistor and whose second terminal is connected to the output terminal of the current-voltage conversion circuit, a fifth resistor having one end connected to the second terminal of the third transistor and another end connected to ground, and a sixth resistor having one end connected to the second terminal of the fourth transistor and another end connected to be ground.

In this case, contributions of impedance of the second terminal internal resistor and the feedback circuit can be reduced at the second terminal resistors of the third transistor and the fourth transistor. Therefore, a fluctuation in a gain according to the configuration of the feedback circuit can be further repressed.

### BRIEF DESCRIPTION OF THE DRAWINGS

Fig. 1 is a typical circuit diagram illustrating one example of the current-voltage conversion circuit;
Fig. 2 is a typical circuit diagram illustrating another example of the current-voltage conversion circuit;
Fig. 3 is a typical circuit diagram illustrating still another example of the current-voltage conversion circuit; and
Fig. 4 is a typical circuit diagram illustrating still another example of the current-voltage conversion circuit.

### DETAILED DESCRIPTION OF THE PREFERRED EMBODIMENTS

Embodiments of the present invention will be described below with reference to the drawings.

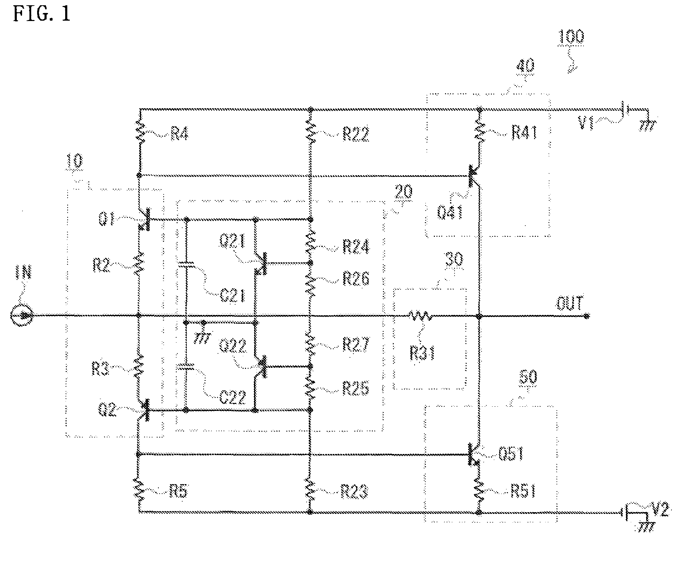

Fig. 1 is a typical circuit diagram illustrating one example of a current-voltage conversion circuit. The current-voltage conversion circuit 100 includes the input terminal IN, the input stage 10, the bias circuit 20, the output resistor section 30 and the output stages 40 and 50.

### (Input Stage 10)

The input stage 10 includes an NPN transistor Q1, a PNP transistor Q2, and the emitter resistors R2 and R3.

As shown in Fig. 1, an emitter of the NPN transistor Q1 is connected to the input terminal IN via the resistor R2. An emitter of the PNP transistor Q2 is connected to the input terminal IN via the resistor R3.

The bias circuit 20 is inserted between a base of the NPN transistor Q1 and a base of the PNP transistor Q2.

A collector of the NPN transistor Q1 is connected to the line of the constant power source V1 via the resistor R4, and a collector of the PNP transistor Q2 is connected to the line of the constant power source V2 via the resistor R5.

### (Bias Circuit 20)

The bias circuit 20 includes the capacitors C21 and C22, the NPN transistor Q21, the PNP transistor Q22, and the resistors R24, R25, R26 and R27.

An emitter of the NPN transistor Q21 is grounded (GND). The capacitor C21 is provided between the emitter and the collector of the NPN transistor Q21, and the resistor R24 is provided between the base and the collector.

The emitter of the PNP transistor Q22 is grounded (GND). The capacitor C22 is provided between the emitter and the collector of the PNP transistor Q22, and the resistor R25 is provide between the collector and the base.

The resistors R26 and R27 are connected between the bases of the NPN transistor Q21 and the PNP transistor Q22 in series.

The bias circuit 20 is connected to the line of the constant power source V1 via the resistor R22, and to the line of the constant power source V2 via the resistor R23.

### (Output Resistor Section 30)

As shown in Fig. 1, the output resistor section 30 has the output resistor R31. The output resistor R31 is inserted between the emitter of the NPN transistor Q1 at the input stage 10 and the emitter of the PNP transistor Q2 and the output terminal OUT. A scale of the output resistor R31 can be determined by an upper limit of an electric current to be input and a upper limit of a voltage to be output. Further, the output resistor R31 shown in Fig. 1 functions as a negative feedback resistor.

### (Output Stage 40)

The output stage 40 includes the PNP transistor Q41 and a resistor R41.

The base of the PNP transistor Q41 is connected to the collector of the NPN transistor Q1 at the input stage. The emitter of the PNP transistor Q41 is connected to the line of the constant power source V1 via the resistor R41. The collector of the PNP transistor Q41 is connected to the output terminal OUT.

### (Output Stage 50)

The output stage 50 includes the NPN transistor Q51 and the resistor R51.

The base of the NPN transistor Q51 is connected to the collector of the PNP transistor Q2 at the input stage. The emitter of the NPN transistor Q51 is connected to the line of the constant power source V2 via the resistor R51. The collector of the NPN transistor Q51 is connected to the output terminal OUT.

If an electric current to be input into the input terminal IN of the current-voltage conversion circuit 100 shown in Fig. 1 reduces, the voltage width of the emitter resistor R2 is widened, and an electric current flowing in the emitter resistor R2 increases according to the input electric current. The electric current flowing in the emitter resistor R2 is added to the resistor R4, and the voltage width of the resistor R4 increases. A voltage to be applied to the emitter resistor 41 is a value obtained by subtracting a value (Vbe) between the base and the emitter of the PNP transistor Q41 from the voltage to be applied to the resistor R4.

It is assumed that an electric current of 1 mA flows in the resistor R4, and an electric current of 10 mA flows in the emitter resistor R41. When the voltage width of the resistor R4 is 1.5 V under this condition, the voltage width of the emitter resistor R41 is 0.9 V according to 1.5 V - (Vbe(Q41)). Further, under that condition, the resistor R4 is 1.5 KΩ, and the resistor R41 is 90 Ω.

When the input current increases from the above state to 10 mA, the voltage width of the resistor R4 is 15 V, and the voltage width of the emitter resistor 41 changes to 14.4 V. Further, when the input current increases, the symmetrical circuit similarly operates.

As described above, in the current-voltage conversion circuit 100, the output resistor section 30 and the output stages 40 and 50 determine an amplification width at a later stage.

In the current-voltage conversion circuit 100 according to the embodiment, the electric current supplied from the input terminal IN is supplied to the NPN transistor Q1 and the PNP transistor Q2 of the input stage 10. The electric current flowing in the NPN transistor Q1 increases and decreases (in the PNP transistor Q2, a reverse operation) according to a rise and a drop of an applied voltage of the NPN transistor Q1. For this reason, the voltages applied from the line of the constant power source V1 and the line of the constant power source V2 are inversely proportional to the voltage in the bias circuit 20, and the voltage can be stably output from the output terminal.

In the current-voltage conversion circuit 100, the bias circuit 20 is put into a floating state from the lines of the constant power sources V1 and V2, and the voltage between the bases of the NPN transistor Q1 and the PNP transistor Q2 can be fixed by the bias circuit 20. Further, a lot of constant current circuits do not have to be provided due to the bias circuit 20, so that the circuit can be simplified. Further, an influence of ripple from the lines of the constant power sources V1 and V2 can be reduced. The drive currents of the transistors Q1 and Q2 are supplied from the bias circuit 20 (particularly, the capacitors C21 and C22) without depending on the constant power sources V1 and V2, so that the drive currents can be instantaneously supplied to the transistors Q1 and Q2. If the drive currents are supplied from the constant power sources V1 and V2 to the transistors Q1 and Q2, high electric currents should always flow in the resistors R22 and R23. For this reason, the power consumption increases, but such a problem can be solved in this example.

In the current-voltage conversion circuit 100 according to the embodiment, since the electric current can be repressed at the stationary time, heat generation can be repressed, thereby improving the temperature stability of the current-voltage conversion circuit 100. Further, the NPN transistor Q21 and the PNP transistor Q22 are thermally bonded to the transistors Q1 and Q2, so that an influence of a change in the characteristics caused by the heats of the respective transistors can be cancelled. As a result, the output voltage can be stabilized. The respective transistors of the output stages 40 and 50 are thermally bonded to the NPN transistor Q21 and the PNP transistor Q22, so that the output voltage can be further stabilized.

The output resistor (negative feedback resistor) R31 can reduce noise and distortion, and can be provided with both functions of the amplifier gain and the output resistor. As a result, the circuit configuration can be simplified.

At the input stage 10, the gain of the NPN transistor Q1 can be adjusted by the emitter resistor R2 and the resistor R4. Further, the gain of the PNP transistor Q2 can be adjusted by the emitter resistor R3 and the resistor R5.

In the current-voltage conversion circuit 100 according to the embodiment, the bases of the NPN transistor Q1 and the PNP transistor Q2 are grounded. As a result, the wide band of the current-voltage conversion circuit 100 can be realized.

### (Another Example)

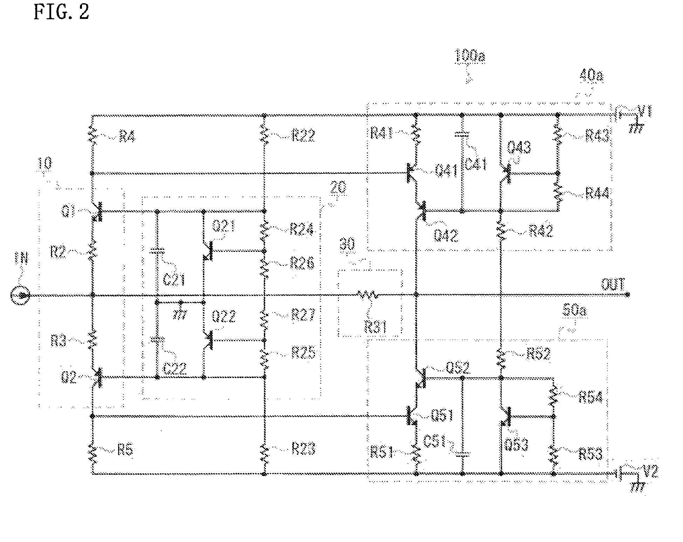

Fig. 2 is a typical circuit diagram illustrating another example of the current-voltage conversion circuit 100. A different point between a current-voltage conversion circuit 100a of another example and the current-voltage conversion circuit 100 according to the first embodiment will be mainly described below.

As shown in Fig. 2, the current-voltage conversion circuit 100a includes output stages 40a and 50a instead of the output stages 40 and 50 of the current-voltage conversion circuit 100. That is to say, the output stages 40a and 50a are constituted by adding a cascode circuit to the output stages 40 and 50.

### (Output Stage 40a)

The output stage 40a includes the PNP transistors Q41, Q42 and Q43, the resistors R41, R42, R43 and R44, and a capacitor C41.

The collector of the PNP transistor Q41 is connected to the emitter of the PNP transistor Q42. The collector of the PNP transistor Q42 is connected to the output terminal OUT.

The base of the PNP transistor Q41 is connected to the collector of the NPN transistor Q1 at the input stage, and the emitter of the PNP transistor Q41 is connected to the line of the constant power source V1 via the resistor R41.

The base of the PNP transistor Q42 is connected to the collector of the PNP transistor Q43. Further, the resistor R42 is inserted between the collector of the PNP transistor Q43 and a collector of an NPN transistor Q53, described later, in series with the resistor R52, described later.

The emitter of the PNP transistor Q43 is connected to the line of the constant power source V1. The base of the PNP transistor Q43 is connected to the line of the constant power source V1 via the resistor R43. Further, the resistor R44 is inserted between the base and the collector of the PNP transistor Q43.

The capacitor C41 is inserted between the collector of the PNP transistor Q43 and the line of the constant power source V1.

### (Output Stage 50a)

The output stage 50a includes the NPN transistors Q51, Q52 and Q53, the resistors R51, R52, R53 and R54, and a capacitor C51.

The collector of the NPN transistor Q51 is connected to the emitter of the NPN transistor Q52. The collector of the NPN transistor Q52 is connected to the output terminal OUT.

The base of the NPN transistor Q51 is connected to the collector of the PNP transistor Q2 at the input stage, and the emitter of the NPN transistor Q51 is connected to the line of the constant power source V2 via the resistor 51.

The emitter of the NPN transistor Q53 is connected to the line of the constant power source V2. The base of the NPN transistor Q53 is connected to the line of the constant power source V2 via the resistor R53. Further, the resistor R54 is inserted between the base and the collector of the NPN transistor Q53. The base of the NPN transistor Q52 is connected to the collector of the NPN transistor Q53.

The capacitor C51 is inserted between the collector of the NPN transistor Q53 and the line of the constant power source V2.

The addition of the cascade circuit can reduce power loss of the transistors Q41 and Q42. Since a mirror effect is not produced, frequency characteristics of the output stages 40a and 50a can be improved.

### (Still Another Example)

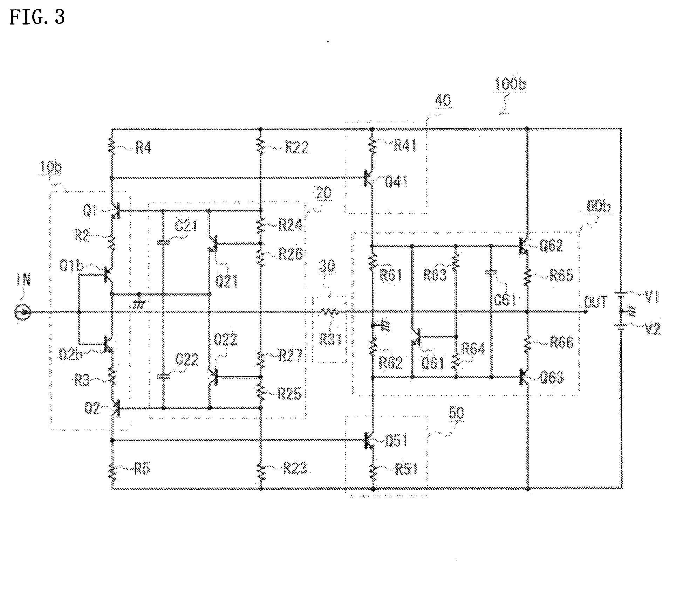

Fig. 3 is a typical circuit diagram illustrating still another example of the current-voltage conversion circuit 100. A current-voltage conversion circuit 100b shown in Fig. 3 includes an input stage 10b instead of the input stage 10 of the current-voltage conversion circuit 100 shown in Fig. 1, and an output stage 60b.

### (Input Stage 10b)

The input stage 10b includes a PNP transistor Q1b, an NPN transistor Q2b, the NPN transistor Q1, the PNP transistor Q2 and the emitter resistors R2 and R3.

As shown in Fig. 1, a base of the PNP transistor Q1b and a base of the NPN transistor Q2b are connected to the input terminal IN. A collector of the PNP transistor Q1b and a collector of the NPN transistor Q2b are connected to each other and are grounded (GND).

The emitter of the NPN transistor Q1 is connected to an emitter of the PNP transistor Q1b via the emitter resistor R2.

The emitter of the PNP transistor Q2 is connected to an emitter of the NPN transistor Q2b via the emitter resistor R3.

The collector of the NPN transistor Q1 is connected to the line of the constant power source V1 via the resistor R4, and the collector of the PNP transistor Q2 is connected to the line of the constant power source V2 via the resistor R5.

### (Output Stage 60b)

The output stage 60b is a circuit for reducing an output impedance. The output stage 60b includes an NPN transistors Q61 and Q62, a PNP transistor Q63, resistors R61, R62, R63, R64, R65 and R66, and a capacitor C61.

A collector of the NPN transistor Q62 is connected to the line of the constant power source V1. A base of the NPN transistor Q62 is connected to the collector of the PNP transistor Q41. An emitter of the NPN transistor Q62 is connected to the output terminal OUT via the resistor R65.

A collector of the PNP transistor Q63 is connected to the line of the constant power source V2. A base of the PNP transistor Q63 is connected to a collector of the NPN transistor Q51. An emitter of the PNP transistor Q63 is connected to the output terminal OUT via the resistor R66.

An emitter of the NPN transistor Q61 is connected between the base of the PNP transistor Q63 and the collector of the NPN transistor Q51. The resistor R63 is connected between the base and the collector of the NPN transistor Q61, and the resistor R64 is connected between the base and the emitter of the NPN transistor Q61.

The capacitor C61 is provided between the base of the NPN transistor Q62 and the base of the PNP transistor Q63. Further, the resistor R61 and the resistor R62 are provided between the collector of the PNP transistor Q41 and the collector of the NPN transistor Q51. A portion between the resistor R61 and the resistor R62 are grounded (GND).

As described above, the output stage 60b whose output impedance is low, namely, the output stage whose voltage amplification is low and current amplification is high is provided. As a result, the current-voltage conversion can be efficiently performed.

### (Still Another Example)

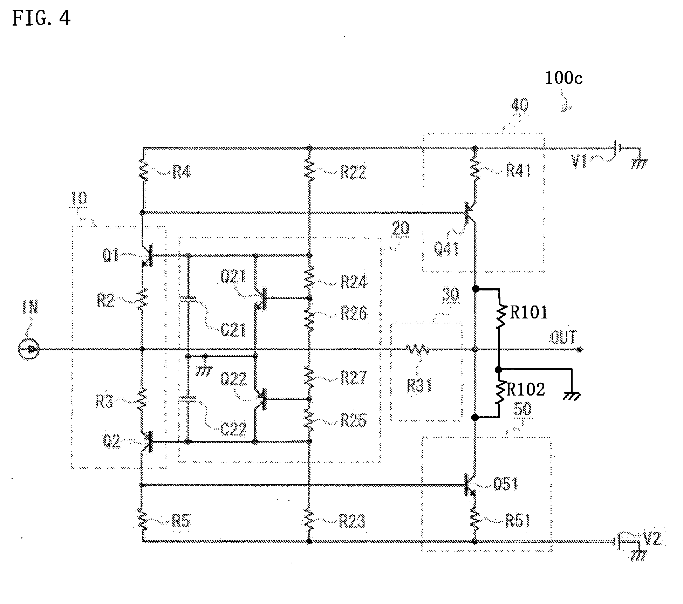

As shown in Fig. 4, in comparison with Fig. 1, the current-voltage conversion circuit 100c further includes the resistors R101 and R102. One end of the resistor R101 is connected to the collector of the transistor Q41, and the other end is grounded. One end of the resistor R102 is connected to the collector of the transistor Q51, and the other end is grounded. The collectors of the transistors Q41 and Q51 are grounded via the resistors R101 and R102, so that the gains of the output stages 40 and 50 can be prevented from being fluctuated by the resistor R31 of the output resistor section 30. The resistor R101 will be described below as an example, and the same is true for the resistor R102.

The resistor R41 is an emitter resistor of the transistor Q41. A collector resistor of the transistor Q41 is represented by a resistor obtained by synthesizing the resistor R101, a collector internal resistor of the transistor Q41 and the resistor R31. When an output admittance of the transistor Q41 is denoted by hoe, the collector internal resistor is represented by (1/hoe). When a resistance value of the resistor R101 is much lower than the collector internal resistor of the transistor Q41 and the resistor R31, contribution of the resistor R101 is dominant in the collector resistor, and thus contribution of the resistor R31 is reduced.

When the resistor R101 is not connected, the resistor R31 is lower than the collector internal resistor, and the resistor R31 is dominant in the collector resistor of the transistor Q41. That is to say, the gain fluctuates due to the resistance value of the resistor R31. However, the provision of the resistor R101 can repress an influence to be exerted on the gain of the resistor R31.

In the current-voltage conversion circuits 100, 100a and 100c, the bias circuit 20 is connected between the base of the NPN transistor Q1 and the base of the PNP transistor Q2. For this reason, the bias circuit 20 is put into a pulled-up state (called also as a floating state), and a plurality of the bias circuits 20 does not have to be provided, thereby simplifying the circuit configuration of the current-voltage conversion circuits 100, 100a and 100b.

In the current-voltage conversion circuits 100, 100a of the present invention, since the temperature can be compensated in the bias circuit 20, thermal runway of the transistors is prevented. As a result, the temperature stability of the current-voltage conversion circuits 100 and 100a can be heightened.

The NPN transistor Q1 and the PNP transistor Q2 are thermally bonded to each other, so that the temperature stability of the current-voltage conversion circuits 100 and 100a can be heightened.

An amplifying amount in the current-voltage conversion circuits 100, 100a and 100b can be determined by a ratio of the resistor R2 and the resistor R4, and a ratio of the resistor R3 and the resistor R5. As a result, the resistors R2, R3, R4 and R5 are also fixed resistors, and thus linearity of the amplification of the current-voltage conversion circuits 100, 100a and 100b can be improved.

The current-voltage conversion circuits 100 and 100a according to this embodiment is designed so that the output resistor R31/amplifier gain is smaller than the resistor R2 and the resistor R3. Thus, it is not necessary to add further transistor to the input stage 10to constitute an emitter follower. As a result, a number of parts can be reduced, and thus the circuit configuration can be simplified.

In the above embodiments, a compensating circuit is not provided, but not limited to this, and, for example, a phase compensating circuit may be provided to the output resistor R31.

## Claims

1. A current-voltage conversion circuit, comprising:
a first transistor (Q1) provided in an input stage (10);
a second transistor (Q2) provided in the input stage (10) and having a polarity different from that of the first transistor (Q1); and
a bias circuit (20) including two capacitors (C21, C22), an NPN transistor (Q21) and a PNP transistor (Q22), wherein one (C21) of the two capacitors is directly coupled between an emitter and a collector of the NPN transistor (Q21) and the other one (C22) of the two capacitors is directly coupled between an emitter and a collector of the PNP transistor (Q22), wherein
a first terminal of the first transistor (Q1) and a first terminal of the second transistor (Q2) are connected to an input terminal (IN) into which an input current can be input,
a second terminal of the first transistor (Q1) is connected to a first predetermined potential,
a second terminal of the second transistor (Q2) is connected to a second predetermined potential,
the bias circuit (20) is connected between a control terminal of the first transistor (Q1) and a control terminal of the second transistor (Q2), so that the collector of the NPN transistor (Q21) is connected to the control terminal of the first transistor (Q1), and the collector of the PNP transistor (Q22) is connected to the control terminal of the second transistor (Q2) the emitter of the NPN transistor (Q21) and the emitter of the PNP transistor (Q22) are connected to each other and grounded.

2. The current-voltage conversion circuit according to claim 1, further comprising:
a first resistor (R2), a second resistor (R3), a third resistor (R4) and a fourth resistor (R5), wherein
the first resistor (R2) is connected between the first terminal of the first transistor (Q1) and the input terminal (IN),
the second resistor (R3) is connected between the first terminal of the second transistor (Q2) and the input terminal (IN),
the third resistor (R4) is connected to the second terminal of the first transistor (Q1),
the fourth resistor (R5) is connected to the second terminal of the second transistor (Q2).

3. The current-voltage conversion circuit according to claim 1 or 2, further comprising:
a third transistor (Q41) whose control terminal is connected to the second terminal of the first transistor (Q1) and whose second terminal is connected to an output terminal (OUT) of the current-voltage conversion circuit (100),
a fourth transistor (Q51) whose control terminal is connected to the second terminal of the second transistor (Q2) and whose second terminal is connected to the output terminal (OUT) of the current-voltage conversion circuit (100),
a fifth resistor (R41) having one end connected to the second terminal of the third transistor (Q41) and another end connected to ground, and
a sixth resistor (R51) having one end connected to the second terminal of the fourth transistor (Q51) and another end connected to ground.

## Patentansprüche

1. Strom-Spannungswandlerschaltung, aufweisend:
einen ersten Transistor (Q1), der in einer Eingangsstufe (10) vorgesehen ist;
einen zweiten Transistor (Q2), der in der Eingangsstufe (10) vorgesehen ist und eine Polarität aufweist, die sich von der des ersten Transistors (Q1) unterscheidet;
eine Vorspannungsschaltung (20), die zwei Kondensatoren (C21, C22), einen NPN-Transistor (Q21) und einen PNP-Transistor (Q22) aufweist, wobei einer (C21) der zwei Kondensatoren direkt zwischen einem Emitter und einem Kollektor des NPN-Transistors (Q21) angeschlossen ist und der andere (C22) der zwei Kondensatoren direkt zwischen einem Emitter und einem Kollektor des PNP-Transistors (Q22) angeschlossen ist;
wobei ein erster Anschluss des ersten Transistors (Q1) und ein erster Anschluss des zweiten Transistors (Q2) mit einem Eingangsanschluss verbunden sind, in den ein Eingangsstrom eingegeben werden kann;
ein zweiter Anschluss des ersten Transistors (Q1) mit einem ersten vorbestimmten Potential verbunden ist;
ein zweiter Anschluss des zweiten Transistors (Q2) mit einem zweiten vorbestimmten Potential verbunden ist;
die Vorspannungsschaltung (20) zwischen einem Steueranschluss des ersten Transistors (Q1) und einem Steueranschluss des zweiten Transistors (Q2) verbunden ist, so dass der Kollektor des NPN-Transistors (Q21) mit dem Steueranschluss des ersten Transistors (Q1) verbunden ist, der Kollektor des PNP-Transistors (Q22) mit dem Steueranschluss des zweiten Transistors (Q2) verbunden ist, und der Emitter des NPN-Transistors (Q21) und der Emitter des PNP-Transistors (Q22) miteinander verbunden und an Masse angeschlossen sind.

2. Strom-Spannungswandlerschaltung gemäß Anspruch 1, weiterhin aufweisend:
einen ersten Widerstand (R2), einen zweiten Widerstand (R3), einen dritten Widerstand (R4) und einen vierten Widerstand (R5), wobei:
der erste Widerstand (R2) zwischen dem ersten Anschluss des ersten Transistors (Q1) und dem Eingangsanschluss (IN) verbunden ist;
der zweite Widerstand (R3) zwischen dem ersten Anschluss des zweiten Transistors (Q2) und dem Eingangsanschluss (IN) verbunden ist;
der dritte Widerstand (R4) mit dem zweiten Anschluss des ersten Transistors (Q1) verbunden ist; und
der vierte Widerstand (R5) mit dem zweiten Anschluss des zweiten Transistors (Q2) verbunden ist.

3. Strom-Spannungswandlerschaltung gemäß Anspruch 1 oder 2, weiterhin aufweisend:
einen dritten Transistor (Q41) dessen Steueranschluss mit dem zweiten Anschluss des ersten Transistors (Q1) verbunden ist und dessen zweiter Anschluss mit einem Ausgangsanschluss (OUT) der Strom-Spannungswandlerschaltung (100) verbunden ist;
einen vierten Transistor (Q51) dessen Steueranschluss mit dem zweiten Anschluss des zweiten Transistors (Q2) verbunden ist und dessen zweiter Anschluss mit dem Ausgangsanschluss (OUT) der Strom-Spannungswandlerschaltung (100) verbunden ist;
einen fünften Widerstand (R41) dessen eines Ende mit dem zweiten Anschluss des dritten Transistors (Q41) und dessen anderes Ende mit Masse verbunden ist; und
einen sechsten Widerstand (R51) dessen eines Ende mit dem zweiten Anschluss des vierten Transistors (Q51) und dessen anderes Ende mit Masse verbunden ist.

## Revendications

1. Circuit de conversion courant-tension, comprenant :
- un premier transistor (Q1) disposé dans un étage d'entrée (10) ;
- un second transistor (Q2) disposé dans l'étage d'entrée (10) et ayant une polarité différente de celle du premier transistor (Q1) ; et
- un circuit de polarisation (20) comprenant deux condensateurs (C21, C22), un transistor NPN (Q21) et un transistor PNP (Q22), dans lequel l'un (C21) des deux condensateurs est directement couplé entre un émetteur et un collecteur du transistor NPN (Q21), et l'autre (C22) des deux condensateurs est directement couplé entre un émetteur et un collecteur du transistor PNP (Q22),
dans lequel
une première borne du premier transistor (Q1) et une première borne du second transistor (Q2) sont reliées à une borne d'entrée (IN) à laquelle un courant d'entrée peut être appliqué,
une seconde borne du premier transistor (Q1) est reliée à un premier potentiel prédéterminé,
une seconde borne du second transistor (Q2) est reliée à un second potentiel prédéterminé,
le circuit de polarisation (20) est connecté entre une borne de commande du premier transistor (Q1) et une borne de commande du second transistor (Q2), de sorte que le collecteur du transistor NPN (Q21) est relié à la borne de commande du premier transistor (Q1), et le collecteur du transistor PNP (Q22) est relié à la borne de commande du second transistor (Q2), l'émetteur du transistor NPN (Q21) et l'émetteur du transistor PNP (Q22) sont reliés l'un à l'autre et sont mis à la terre.

2. Circuit de conversion courant-tension selon la revendication 1, comprenant en outre :
- une première résistance (R2), une seconde résistance (R3), une troisième résistance (R4) et une quatrième résistance (R5), dans lequel
la première résistance (R2) est connectée entre la première borne du premier transistor (Q1) et la borne d'entrée (IN),
la seconde résistance (R3) est connectée entre la première borne du second transistor (Q2) et la borne d'entrée (IN),
la troisième résistance (R4) est reliée à la seconde borne du premier transistor (Q1),
la quatrième résistance (R5) est reliée à la seconde borne du second transistor (Q2).

3. Circuit de conversion courant-tension selon la revendication 1 ou 2, comprenant en outre :
- un troisième transistor (Q41) dont la borne de commande est reliée à la seconde borne du premier transistor (Q1) et dont la seconde borne est reliée à une borne de sortie (OUT) du circuit de conversion courant-tension (100),
- un quatrième transistor (Q51) dont la borne de commande est reliée à la seconde borne du second transistor (Q2) et dont la seconde borne est reliée à la borne de sortie (OUT) du circuit de conversion courant-tension (100),
- une cinquième résistance (R41) dont une extrémité est reliée à la seconde borne du troisième transistor (Q41) et une autre extrémité est reliée à la terre, et
- une sixième résistance (R51) dont une extrémité est reliée à la seconde borne du quatrième transistor (Q51) et une autre extrémité est reliée à la terre.
